Europäisches Patentamt

European Patent Office

Office européen des brevets

(11) Publication number: **0 179 369**
A2

# EUROPEAN PATENT APPLICATION

(21) Application number: **85112921.3**

(22) Date of filing: **11.10.85**

(51) Int. Cl.⁴: **H 01 L 23/52**

(30) Priority: **22.10.84 JP 220414/84**

(43) Date of publication of application:
**30.04.86 Bulletin 86/18**

(84) Designated Contracting States:
**DE FR GB**

(71) Applicant: HITACHI, LTD.
6, Kanda Surugadai 4-chome Chiyoda-ku
Tokyo 100(JP)

(72) Inventor: Nishino, Yoichi
4-14-6, Nishikaigakubo
Kokubunji-shi Tokyo(JP)

(72) Inventor: Hinode, Kenji
E103, 2-32, Koyasu-cho
Hachioji-shi Tokyo(JP)

(72) Inventor: Kawamura, Masao
1-5-14, Shinmachi
Fuchu-shi Tokyo(JP)

(74) Representative: Strehl, Schübel-Hopf, Schulz
Widenmayerstrasse 17 Postfach 22 03 45
D-8000 München 22(DE)

(54) Electrode and/or interconnection.

(57) An electrode and/or interconnection formed by a single crystalline metal or alloy film is disclosed.

In comparison with conventional electrodes and/or interconnections formed by polycrystalline metal or alloy, the short or open fault of the electrode and/or interconnection resulting from electromigration is by far less likely to occur. The electrode and/or interconnection of the present invention is particularly effective for improving the reliability of miniature electrodes and/or interconnections whose line width is up to about 3 μm.

FIG. 2

EP 0 179 369 A2

Croydon Printing Company Ltd.

ELECTRODE AND/OR INTERCONNECTION

BACKGROUND OF THE INVENTION

This invention relates to an electrode and/or interconnection. More particularly, the present invention relates to electrodes and/or interconnections of various semiconductor devices and surface-acoustic-wave devices.

As a remarkable progress has been made in recent years in miniaturization and integration density of semiconductor devices and surface-acoustic-wave devices, the line width of electrodes and/or interconnections and the distances between the electrodes and/or interconnections of these devices have been reduced remarkably.

As a result, many problems such as the short and open fault of the interconnections and the occurrence of electromigration are more likely to occur.

To solve these problems, many methods have also been proposed as disclosed, for example, in Japanese Patent Laid-Open No. 31619/1980, but the conventional methods have not entirely been satisfactory to effectively prevent such problems.

## SUMMARY OF THE INVENTION

The object of the present invention is to provide highly reliable electrodes and/or interconnections which can solve the various problems of the conventional electrodes and/or interconnections and can effectively prevent the occurrence of the short and open fault of the interconnections and the occurrence of the electromigration even when the line width is extremely small.

To accomplish the object described above, the present invention uses a film substantially consisting of a single crystalline conductor as a electrode and/or interconnection and prevents the short or open fault of the interconnection at the grain boundary in the interconnection.

## BRIEF DESCRIPTION OF THE DRAWINGS

Figs. 1 and 2 are diagrams useful for explaining the effect of the present invention; and

Fig. 3 is a sectional view showing one embodiment of the present invention.

## DESCRIPTION OF THE PREFERRED EMBODIMENTS

As a result of studies, the inventors of the present invention have come to acquire the following observation. When an interconnection is formed using aluminum or an aluminum alloy as the material in accordance with a semiconductor fabrication process that is generally employed at present, the line width and film thickness of an aluminum or aluminum alloy film are remarkably etched when the aluminum or aluminum alloy film is photo-etched in a desired shape if the line width of the inter-connection is below about 3μm, and when such a film is used in practice, the short or open fault occurs at this boundary.

The inventors of the present invention have also found that the occurrence of the short or open fault of the interconnection at the boundary can be effectively prevented by use of a single crystalline conductor film in place of a conventional polycrystalline conductor film as the interconnection.

On the basis of the novel finding described above, the present invention uses a film substantially consisting of single crystalline conductor material such as aluminum or aluminum alloy for an electrode and/or interconnection of various semiconductor devices and surface-acoustic-wave devices, and prevents the reduction of the line width and film thickness at the grain boundary at the time of etching, and also the short and open fault of the interconnection resulting from the former.

When the single crystalline film of a conductor material is used as the electrode and/or interconnection, it does not occur that a specific portion is excessively etched so that the partial reduction of the line width and film thickness does not occur in the electrode and/or connection, and the occurrence of the short and open fault and the occurrence of the electromigration can be prevented effectively.

Example 1:

A 1 μm-thick aluminum film was formed on the entire surface of a sapphire (α-Aℓ₂O₃) substrate of a surface orientation (001) by a vacuum evaporation method using an electron beam.

The sapphire substrate was held at 500°C in an Ar atmosphere, and the surface of the substrate was locally heated up to the melting point of aluminum by a carbon strip heater in order to partially fuse the aluminum film formed on the substrate.

Next, the carbon strip heater was gradually moved from one of the ends to the other of the substrate.

In this process, the aluminum film formed on the substrate was fused when the carbon strip heater came thereon because the temperature was raised, but when the heater passed away, the temperature dropped and the aluminum film again solidified to a solid. It was found that if the moving speed of the carbon strip heater was below 5 mm/sec in this case, the aluminum film was turned into a single crystalline film. Consequently, this embodiment set the moving speed to 0.5 mm/sec and formed the single crystalline aluminum film.

Incidentally, single crystallization due to the heat-treatment by use of the carbon strip heater could be confirmed extremely easily by an X-ray diffraction method and an electron diffraction method.

The unnecessary portions of the single crystalline aluminum film were selectively removed by ordinary photoetching to form an interconnection pattern.

After a 2 μm-thick $SiO_2$ film was formed as a passivation film in such a manner as to cover the interconnection thus formed, a high temperature aging test was carried out to determine the open failure rate of the interconnection.

The interconnections subjected to the test were 1 μm thick and 1 m long but were 1, 2 and 3 μm wide, respectively. 100 pieces each of these three kinds of inter-connections were held at 250°C, and the number of occurrence of the short or open faults was counted with the passage of time.

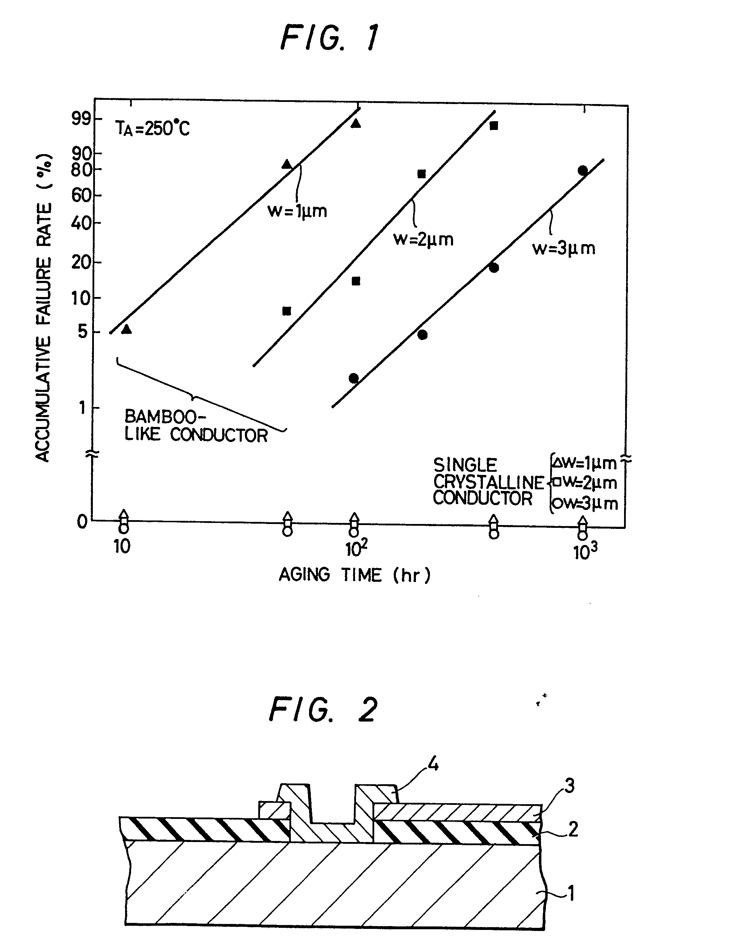

For comparison, interconnections each consisting of polycrystalline aluminum and having a bamboo-like structure (in which one grain boundary crossed transversely the interconnection) were subjected to the same tests. The results of these tests were shown in Fig. 1.

- 6 -

0179369

In Fig. 1, symbols $\triangle$ , $\square$ , $\bigcirc$ represent the results obtained from the single crystalline aluminum interconnections whose line widths w were 1, 2 and 3 μm, respectively, and symbols $\blacktriangle$ , $\blacksquare$ , $\bullet$ represent the results from the polycrystalline silicon interconnections whose line widths w are 1, 2 and 3 μm, respectively, and which had the bamboo-like structure.

As can be seen clearly from Fig. 1, no short or open fault of the interconnection occurred not only in the interconnections having a large line width but also in the interconnections having the smallest line width w = 1 μm when the interconnections were held at 250°C for 1,000 hours in the interconnections of the present invention consisting of the single crystalline aluminum film.

In contrast, in the conventional interconnections (consisting of polycrystalline aluminum) having the bamboo-like structure, the short or open fault occurred within a short period. In the case of the interconnections whose line widths w was 1 μm, for example, 5% failure occurred within only 10 hours.

Example 2:

A current test was carried out for single crystalline aluminum interconnections fabricated in the same way as in Example 1 by causing a current to flow through them, in order to measure an open failure rate.

Ten each interconnections having line widths of 1, 2 and 3 μm, respectively, were held at 250°C and a current was caused to flow under the condition of a current density of 1x10$^6$ A/cm$^3$ to measure the time at which the open of the interconnections occurred. Incidentally, the passivation film was not formed on the interconnection.

The same current test was conducted also for the polycrystalline aluminum interconnections having the bamboo-like structure for comparison.

The mean life time was determined from the resulting measured values, and the result was shown in Table 1. As is clearly shown in Table 1, it was found that the mean life of the interconnection from the beginning of flow of the current to the open failure due to the electromigration in the case of single crystalline aluminum interconnection was roughly two or three times as long as that of the bamboo-like interconnection consisting of polycrystalline aluminum.

Table 1

| line width (μm) interconnection | 1.0 | 2.0 | 3.0 |
|---|---|---|---|
| single crystalline conductor | 45 | 51 | 81 |
| bamboo-like conductor | 16 | 21 | 42 |

250°C, 1x10$^6$A/cm$^2$

Example 3:

A 500 nm thick Aℓ₂O₃ film was first formed as an insulator film on an Si single crystalline substrate 1 of a surface orientation (001) as shown in Fig. 2, and the single crystalline aluminum film was then formed in the same way as in Example 1. The unnecessary portions were removed selectively by known photoetching in order to form an interconnection layer 3 consisting of the single crystalline aluminum. The desired portions of the interconnection layer 3 and Aℓ₂O₃ film 2 were selectively removed to expose the surface of the semiconductor substrate 1 and to form contact holes.

Next, an Aℓ film 4 consisting of polycrystalline aluminum was formed in the contact hole by known vacuum evaporation and photoetching, and an interconnection layer 3 consisting of single crystalline Aℓ and the substrate 1 was electrically connected by the Aℓ film 4.

In this embodiment, too, it was confirmed that the interconnection consisting of the single crystalline aluminum film and having a width below about 3 μm exhibited by far longer life than the conventional interconnection consisting of polycrystalline aluminum film. Incidentally, it is of course possible to extend the single crystalline aluminum film 3 into the contact hole and to connect it directly to the substrate 1 without

- 9 -

0179369

using the Aℓ film 4 consisting of the polycrystalline aluminum.

Example 4:

After a 900 nm thick $SiO_2$ film was formed on the Si single crystalline substrate, a 2 μm-thick Aℓ film was formed on the $SiO_2$ film in the same way as in Example 1.

This aluminum film was crystallized to the single crystal in the same way as in Example 1, and the unnecessary portions were selectively removed by photoetching, thereby forming an interconnection consisting of the single crystalline aluminum.

The life of the interconnection formed in this manner was two or three times as long as that of the conventional interconnection consisting of the polycrystalline aluminum.

Example 5:

A 300 nm thick $SiO_2$ film and a 10 nm thick aluminum oxide film were superposedly formed on a single crystalline Si substrate.

An interconnection consisting of single crystalline aluminum film was formed on the aluminum oxide film described above in the same way as in Example 1.

It was confirmed that the life of the resulting interconnection was by far longer than the life of the conventional interconnection consisting of polycrystalline aluminum.

Example 6:

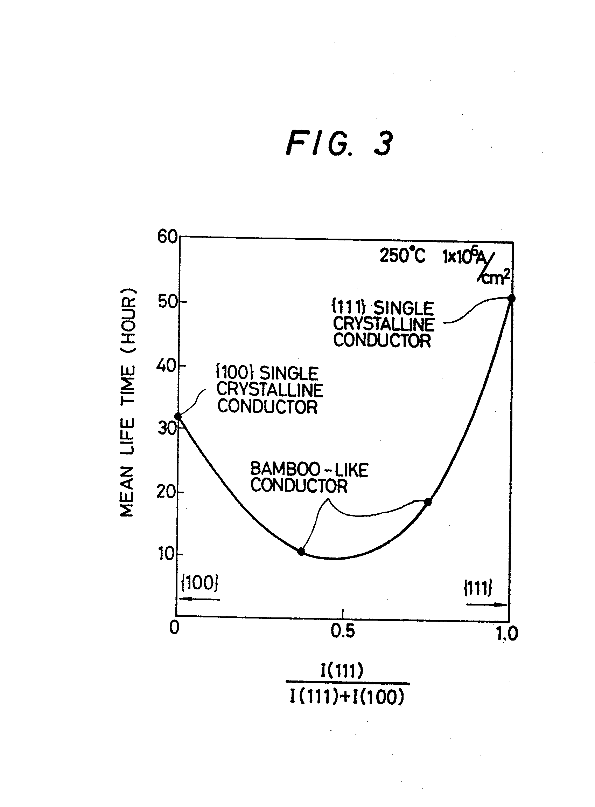

Two types of interconnections consisting of single crystalline
aluminum having the surface orientation of 111 and
{100}, respectively were formed in the same way as in Example 1, and
the respective single crystalline aluminum interconnections were subjected to a current test to determine an
open failure rate. In other words, each interconnection
which was 1 μm thick, 2 μm wide and 1 mm long (but not
equipped with a passivation film) was held at 250°C,
and a current was caused to flow at a current density of
$1 \times 10^6$ A/cm$^2$ to measure the life time necessary to gat the open
failure of interconnection. The result is shown in Fig.3. For
comparison, the similar test was conducted for polycrystalline aluminum interconnections having a bamboo-
like structure, which were produced in accordance with a conventional method, and the result was also shown in Fig. 3.
Since the surface orientation of the crystal grains of
each interconnection consisting of polycrystalline
aluminum was {111} or {100}, <111> X-ray reflection
intensity $I_{(111)}$ and <200> reflection intensity $I_{(200)}$ were measured
by an X-ray diffractomer, and the ratio $I_{(111)}/\{I_{(111)} + I_{(100)}\}$ was plotted on the axis of
abscissa of Fig. 3. As can be seen clearly from this diagram, each of the {111} single crystalline interconnection and the {100} single crystalline interconnection exhibited mean life time by several times longer
than that of the bamboo-like interconnections consisting
of polycrystalline aluminum having both {111} and {100}
surface otientations. It was confirmed further that the
{111} interconnection had higher reliability than the
{100} interconnection.

The present invention can effectively prevent the
problems such as electromigration resulting from the
miniaturization of interconnections and can also prevent
the short or open fault of the interconnections at the grain
boundary that exists in the interconnection while crossing it transversely. Therefore, the present invention
is extremely effective as electrodes and/or interconnections of various semiconductor elements or devices
having a high intergration density.

Although the foregoing Examples use a strip heater
in order to heat and crystallize the aluminum film to
the single crystalline aluminum film, the present invention can also use various other heating means such as
infrared lamps, laser beam, electron beams, and the like,
besides the strip heater.

Although aluminum is used in the foregoing Examples
as the conductor film of the electrode and/or interconnection, the conductor film in the present invention is not naturally limited to the aluminum film, but single crystalline films of various aluminum alloys, copper or copper alloys can also be used. For example, aluminum or copper alloys prepared by adding up to about 1% of other alloy elements to Aℓ or Cu, such as Aℓ-Si, Aℓ-Mg, Aℓ-Cu, Aℓ-Ti, Cu-Mg, Cu-Ge, Cu-P, Cu-Si and Cu-Be, can also be easily crystallized to single crystal in the same way as Aℓ and Cu, and can therefore be used in the present invention.

CLAIMS:

1.  An electrode and/or interconnection substantially consisting of a single crystalline metal or alloy film having a desired shape.

2.  The electrode and/or interconnection as defined in claim 1 wherein said metal and said alloy are aluminum and an aluminum alloy, respectively.

3.  The electrode and/or interconnection as defined in claim 2 wherein said aluminum alloy is an Aℓ-Si alloy, an Aℓ-Mg alloy, an Aℓ-Cu alloy or an Aℓ-Ti alloy.

4.  The electrode and/or interconnection as defined in claim 1 wherein said metal and said alloy is copper and a copper alloy, respectively.

5.  The electrode and/or interconnection as defined in claim 4 wherein said copper alloy is a Cu-Mg alloy, a Cu-Ge alloy, a Cu-P alloy, a Cu-Si alloy or a Cu-Be alloy.

6.  The electrode and/or interconnection as defined in claim 1 wherein said electrode and/or interconnection is up to about 3 μm wide.

7.  The electrode and/or interconnection as defined in any of claims 1 to 6 wherein said single crystalline metal or alloy film (3) is formed on an insulator film (2), and is electrically connected to a substrate (1) through a polycrystalline conductor (4) formed inside a contact hole of said insulator film (2).

8. The electrode and/or interconnection as defined in any of claims 1 to 6 wherein said single crystalline metal or alloy film (3) is electrically connected to a substrate (1) and extends on an insulator film (2) formed on said substrate (1).

# FIG. 1

# FIG. 2

FIG. 3

0179369